# EUROPÄISCHE PATENTANMELDUNG

(11) **EP 1 624 566 A1**
(43) Veröffentlichungstag der Anmeldung: **08.02.2006**
(21) Anmeldenummer: 05015687.6
(22) Anmeldetag: 19.07.2005
(51) Int. Cl.: H03G 3/32

(54) **Navigationsgestützte geschwindigkeitsabhängige Lautstärkeregelung**

(30) Priorität: 05.08.2004 DE 102004038151
(71) Anmelder: Harman Becker Automotive Systems GmbH, 76307 Karlsbad (DE)
(72) Erfinder: Russlies, Lars, 22145 Hamburg (DE); Wietzke, Joachim, Dr., 76228 Karlsruhe (DE)
(74) Vertreter: Grünecker, Kinkeldey, Stockmair & Schwanhäusser Anwaltssozietät

(57) **Zusammenfassung**

Die vorliegende Erfindung betrifft ein Verfahren und eine Vorrichtung zur geschwindigkeitsabhängigen Lautstärkeregelung in einem Fahrzeug mit einer Navigationseinrichtung, wobei die Navigationseinrichtung Informationen über die momentane Geschwindigkeit des Fahrzeugs zur Verfügung stellt und mit dem Audiosystem verbunden ist.

Das Verfahren zeichnet sich dadurch aus, dass die Abhängigkeit der zu regelnden Lautstärke des Audiosystems von der Geschwindigkeit des Fahrzeugs festgelegt wird und die Lautstärke des Audiosystems gemäß der festgelegten Abhängigkeit der zu regelnden Lautstärke des Audiosystems von der Geschwindigkeit des Fahrzeugs und auf der Grundlage der von der Navigationseinrichtung zur Verfügung gestellten Information über die momentane Geschwindigkeit des Fahrzeugs geregelt wird.

Das ertndungsgemäße Navigationssystem zeichnet sich dadurch aus, dass es einen Controller umfasst, der Signale zur Regelung der Lautstärke eines Audiosystems an dieses Audiosystem ausgibt, wobei diese Signale gemäß einer der Weiterbildungen des erfindungsgemäßen Verfahrens codiert werden.

## Beschreibung

### Gebiet der Erfindung

Die vorliegende Erfindung betrifft ein Verfahren und eine Vorrichtung zur geschwindigkeitsabhängigen Lautstärkeregelung in Fahrzeugen. Insbesondere betrifft die Erfindung ein Verfahren und eine Vonichtung zur geschwindigkeitsabhängigen Lautstärkeregelung in Fahrzeugen, die mit einer Navigationseinrichtung ausgestattet sind, und in denen die Navigationseinrichtung Informationen über die momentane Geschwindigkeit des Fahrzeugs zur Verfügung stellt.

### Stand der Technik

Die unterschiedlichen Geräuschpegel in Fahrzeugen bei vorgegeben äußeren Umständen, wie Wetterverhältnisse und Reifenwahl, in Abhängigkeit von der Fahrzeuggeschwindigkeit führen auf die Notwendigkeit, die Lautstärke von Audiosystemen während der Fahrt häufig zu variieren.

Bei hohen Fahrzeuggeschwindigkeiten, beispielsweise auf der Autobahn, muss sowohl auf Grund des erhöhten Motorgeräuschs als auch insbesondere wegen der erhöhten Außengeräusche die Lautstärke erhöht werden. In Baustellenbereichen oder in Staus wird sie dann als zu laut empfunden und muss wieder heruntergeregelt werden.

Zumeist erfolgt die Anpassung der Lautstärke an wechselnde Störgeräusche manuell. Die Lautstärke kann jedoch auch automatisch in Abhängigkeit von der Fahrzeuggeschwindigkeit dem individuellen Bedürfnis des Fahrers und der übrigen Passagiere angepasst werden. Eine solche automatische Lautstärkeregelung erhöht deutlich den Bedienkomfort wie auch die Sicherheit.

Herkömmliche Verfahren zur geschwindigkeitsabhängigen Lautstärkeregelung benutzen als Eingangsdaten für die Regelung der Lautstärke etwa die Windgeschwindigkeit (US2,080,554) oder die Umdrehungszahl des Motors (DE69622788; JP261297). Altemativ kann direkt das Tachosignal als Information über die Geschwindigkeit genutzt werden.

Diese Verfahren haben die Nachteile, dass die Bestimmung der Geschwindigkeit ungenau und/oder aufwendig ist, und der Geräuschpegels in dem Fahrzeug in Abhängigkeit von der Geschwindigkeit nicht als weiteres Datum in die Regelung der Lautstärke eingeht. Im Fall der tachogestützten Regelung ist zudem eine manuelle Anpassung der Abhängigkeit der Geschwindigkeit von der Zahl der je Radumdrehung für die Tachoinformation verwerteten Impulse vonnöten, da die Anzahl der benutzten Impulse stark je nach Hersteller und Fahrzeugtyp variiert.

Die Aufgabe der Erfindung ist es demnach, ein zuverlässiges und für die Benutzer komfortables Verfahren und eine Vorrichtung zur geschwindigkeitsabhängigen Lautstärkeregelung zur Verfügung zu stellen.

### Beschreibung

Die oben genannte Aufgabe wird gelöst durch ein Verfahren gemäß Anspruch 1 zur geschwindigkeitsabhängigen Lautstärkeregelung eines Audiosystems in einem Fahrzeug mit einer Navigationseinrichtung, wobei die Navigationseinrichtung Informationen über die momentane Geschwindigkeit des Fahrzeugs zur Verfügung stellt und mit dem Audiosystem verbunden ist und das Verfahren die Schritte der Festlegung der Abhängigkeit der zu regelnden Lautstärke des Audiosystems von der Geschwindigkeit des Fahrzeugs und der Regelung der Lautstärke des Audiosystems gemäß der festgelegten Abhängigkeit der zu regelnden Lautstärke des Audiosystems von der Geschwindigkeit des Fahrzeugs und auf der Grundlage der von der Navigationseinrichtung zur Verfügung gestellten Information über die momentane Geschwindigkeit des Fahrzeugs umfasst.

Die oben genannte Aufgabe wird zudem gelöst durch ein Navigationssystem für ein Fahrzeug nach Anspruch 11, das dadurch gekennzeichnet ist, dass es einen Controller umfasst, der Signale zur Regelung der Lautstärke eines Audiosystems an dieses Audiosystem ausgibt, wobei diese Signale gemäß einem dem Verfahren nach Anspruch 1 den obigen Ansprüchen codiert werden. In weiteren vorteilhaften Ausführungsformen des erfindungsgemäßen Navigationssystems erfolgt die Codierung der Signale zur Regelung der Lautstärke eines Audiosystems an dieses Audiosystem jeweils gemäß einem der im weiteren erläuterten Verfahren.

Heutzutage können neben immer aufwändigeren und differenzierteren Audiosystemen ebenso Navigationseinrichtungen als Bestandteile der Standardausrüstung in Fahrzeugen der gehobenen Klasse angesehen werden kann. Diese Einrichtungen, unterstützt von Bewegungssensoren, wie Radsensoren und Gyroskopen, dienen der Positionsbestimmung und Routenführung mit Hilfe der über eine Antenne empfangenen GPS (Global Positioning System)-Satelliten-Signale.

Darüber hinaus stellen die Navigationseinrichtungen jedoch auch über Geschwindigkeitssensoren, und gegebenenfalls mit Hilfe der Abgleichung von Sensordaten mit einer digitalen Karte, Informationen über die momentane Geschwindigkeit des Fahrzeugs sehr zuverlässig zur Verfügung. So gibt gemäß einem üblichen Verfahren ein ABS-Radsensor pro Radumdrehung eine feste Anzahl von Impulsen ab, die über die Datenbusse in dem Fahrzeug zum Navigationsrechner gelangen. In dem Navigationsrechner werden die Anzahl der Impulse in ihr Verhältnis zur Zeit und zum Radumfang gesetzt und so die zurückgelegte Strecke und die Geschwindigkeit des Fahrzeugs berechnet. Die Information über die momentane Geschwindigkeit liegt dann typischerweise in digitaler Form vor.

Ist die Abhängigkeit der Lautstärke von der Geschwindigkeit gemäß den Präferenzen des oder der Benutzer bestimmt, so kann die, typischerweise in digitaler Form vorliegende, Information über die Fahrzeuggeschwindigkeit zur automatischen Regelung der geschwindigkeitsabhängigen Lautstärkeregelung genutzt werden.

Die Nutzung der von dem von der Navigationseinrichtung zur Verfügung gestellten Information über die momentane Geschwindigkeit erlaubt höchsten Bedienkomfort und garantiert eine hohe Verlässlichkeit der gewünschten automatischen Lautstärkeregelung und somit stellt die Erfindung eine Verbesserung bestehender Verfahren und Vorrichtungen zur geschwindigkeitsabhängigen Lautstärkeregelung von Audiosystemen in Fahrzeugen dar.

Gemäß einer Weiterbildung des erfindungsgemäßen Verfahrens wird die Abhängigkeit der zu regelnden Lautstärke des Audiosystems von der Geschwindigkeit des Fahrzeugs von einem Benutzer manuell eingestellt. Diese Weiterbildung ist einfach und kostengünstig.

In einer vorteilhaften Weiterbildung des erfindungsgemäßen Verfahrens erfolgt die Festlegung der Abhängigkeit der zu regelnden Lautstärke des Audiosystems von der Geschwindigkeit des Fahrzeugs nach Maßgabe der Abhängigkeit des Geräuschpegels in dem Fahrzeug von der Geschwindigkeit des Fahrzeugs automatisch. Eine manuelle Einstellung der Abhängigkeit der zu regelnden Lautstärke des Audiosystems von der Geschwindigkeit des Fahrzeugs ist also nicht mehr nötig, wodurch der Bedienkomfort erhöht wird.

Vorteilhafterweise wird die Abhängigkeit des Geräuschpegels in dem Fahrzeug von der Geschwindigkeit des Fahrzeugs mit Hilfe mindestens eines in dem Fahrgastraum installierten Mikrophons einmalig ermittelt und gespeichert. Hierbei kann also werksseitig vor der Auslieferung des Fahrzeugs die automatische Lautstärkeregelung unter Berücksichtigung der auftretenden Störgeräusche erfolgen.

In einer Weiterbildung des erfindungsgemäßen Verfahrens wird die Abhängigkeit des Geräuschpegels in dem Fahrzeug von der Geschwindigkeit des Fahrzeugs mit Hilfe mindestens eines in dem Fahrgastraum installierten Mikrophons kontinuierlich während der Benutzung des Fahrzeugs ermittelt.

Durch die kontinuierliche Ermittlung des Geräuschpegels im Fahrzeug in Abhängigkeit von der Geschwindigkeit kann garantiert werden, dass die Lautstärkeregelung an die monientanen Störgeräusche optimal angepasst erfolgt.

Vorteilhafterweise wird von dem Benutzer das gewünschte Verhältnis der zu regelnden Lautstärke zu dem ermittelten Geräuschpegel voreingestellt.

Durch diese Voreinstellung können prinzipiell unterschiedliche äußere Bedingungen, wie Wetterverhältnisse und Reifenwahl berücksichtigt werden. Darüber hinaus können subjektive Hörempfindungen des Benutzers die automatische Lautstärkeregelung mitbestimmen.

Gemäß einer weiteren Weiterbildung kann die Abhängigkeit der zu regelnden Lautstärke von der Geschwindigkeit wahlweise manuell oder auf Grundlage der Bestimmung des Geräuschpegels im Fahrzeug in Abhängigkeit von der Geschwindigkeit mit Hilfe eines oder mehrerer Innenraum-Mikrophone erfolgen. Dem Benutzer stehen somit vielfältige Wahlmöglichkeiten zur Verfügung, von denen er aktuell Gebrauch machen kann.

In einer weiteren vorteilhaften Weiterbildung kann die Abhängigkeit der zu regelnden Lautstärke des Audiosystems von der Geschwindigkeit des Fahrzeugs von dem Benutzer individuell gespeichert werden. Das Speichem individueller Benutzerprofile erhöht in wünschenswerter Weise den Bedienkomfort sowohl nach Maßgabe der äußeren Umstände als auch bei der Nutzung des Fahrzeugs durch unterschiedliche Fahrer.

Schließlich kann gemäß einer weiteren Weiterbildung die geschwindigkeitsabhängige Lautstärkeregelung wahlweise ein- oder ausgeschaltet werden, so dass dem Benutzer sämtliche Wahlmöglichkeiten verbleiben.

In einer Weiterbildung umfasst das Audiosystem beispielhaft Lautsprecher und/oder ein Radio und/oder ein Kassetten-Wiedergabegerät und/oder einen CD-Spieler und/oder ein DVD-Wiedergabegerät und/oder eine Sprachausgabe der Navigationseinrichtung.

Im Folgenden werden zwei Ausführungsformen des erfindungsgemäßen Verfahrens unter Bezugnahme auf die Zeichnung beschrieben.

### Kurzbeschreibung der Zeichnung

Es zeigen
- Figur 1: ein Flussdiagramm einer Ausführungsform des erfindungsgemäßen Verfahrens zur geschwindigkeitsabhängigen Lautstärkeregelung in Fahrzeugen, die mit einer Navigationseinrichtung ausgestattet sind, und
- Figur 2: eine weitere Ausführungsform des erfindungsgemäßen Verfahrens, in der die Abhängigkeit der zu regelnden Lautstärke von der Geschwindigkeit mit Hilfe von Innenraum-Mikrophonen bestimmt wird.

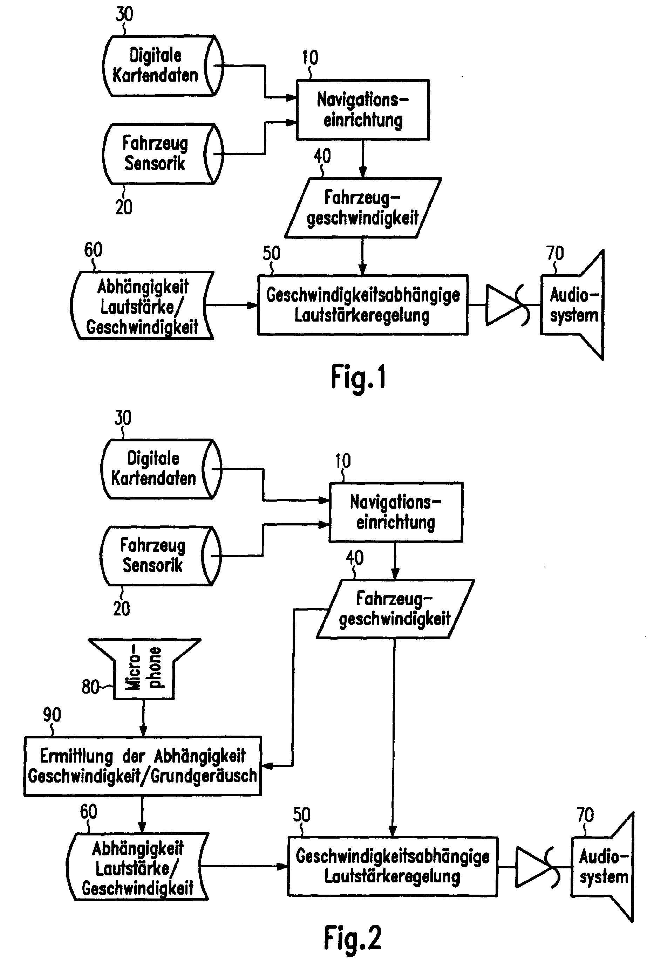

Wie in Figur 1 dargestellt, stellt die Navigationseinrichtung 10 mit Hilfe der Daten der Fahrzeugsensorik 20 sowie der digitalen Kartendaten 30 Informationen über die genaue momentane Fahrzeuggeschwindigkeit 40 zur Verfügung. Die Fahrzeugsensorik 20 umfasst vorteilhafterweise Radsensoren und Gyroskope. Auf diese Geschwindigkeitsdaten, die typischerweise in digitaler Form vorliegen, hat die geschwindigkeitsabhängige Lautstärkeregelung 50 Zugriff. Sie regelt auf der Grundlage der aktuellen Geschwindigkeitsdaten und der festgelegten Abhängigkeit der zu regelnden Lautstärke von der Geschwindigkeit des Fahrzeugs 60 die Lautstärke des Audiosystems 70.

Bei der geschwindigkeitsabhängigen Lautstärkeregelung gemäß der vorliegenden Erfindung werden also die momentane Geschwindigkeit als eine Klasse von Informationen und die vorab bestimmte Abhängigkeit der zu regelnden Lautstärke von der Geschwindigkeit als weitere Klasse von Informationen benötigt. In der beschriebenen Ausführungsform kann die Abhängigkeit der zu regelnden Lautstärke von der Geschwindigkeit wiederum in Abhängigkeit des Geräuschpegels von der Geschwindigkeit festgelegt sein.

Wie in Figur 2 dargestellt, kann in einer beispielhaften weiteren Ausführung der Einsatz von einem oder mehreren Mikrophonen 80 erfolgen. Wieder stellt die Navigationseinrichtung 10 mit Hilfe der Daten der Fahrzeugsensorik 20 sowie der digitalen Kartendaten 30 Informationen über die genaue momentane Fahrzeuggeschwindigkeit 40 zur Verfügung. Die Abhängigkeit der zu regelnden Lautstärke von der Geschwindigkeit 60 erfolgt nun nach Maßgabe der Abhängigkeit des Geräuschpegels im Fahrzeug von der Geschwindigkeit 90. Letztere wird mit Hilfe von Innenraum-Mikrophonen 80 ermittelt. Alternativ kann die Ermittlung der Abhängigkeit des Geräuschpegels im Fahrzeug von der Geschwindigkeit 90 einmalig werksseitig oder aber kontinuierlich während der Fahrt erfolgen. Die geschwindigkeitsabhängige Lautstärkeregelung 50 regelt sodann automatisch auf der Grundlage der aktuellen Geschwindigkeitsdaten 40 und der bestimmten Abhängigkeit der zu regelnden Lautstärke von der Geschwindigkeit 60 nach Maßgabe des ermittelten Geräuschpegels im Fahrzeug in Abhängigkeit von der Geschwindigkeit 90 die Lautstärke des Audiosystems 70.

## Patentansprüche

1. Verfahren zur geschwindigkeitsabhängigen Lautstärkeregelung eines Audiosystems in einem Fahrzeug mit einer Navigationseinrichtung, wobei die Navigationseinrichtung Informationen über die momentane Geschwindigkeit des Fahrzeugs zur Verfügung stellt und mit dem Audiosystem verbunden ist und das Verfahren die folgenden Schritte umfasst:
Festlegung der Abhängigkeit der zu regelnden Lautstärke des Audiosystems von der Geschwindigkeit des Fahrzeugs, und
Regelung der Lautstärke des Audiosystems gemäß der festgelegten Abhängigkeit der zu regelnden Lautstärke des Audiosystems von der Geschwindigkeit des Fahrzeugs und auf der Grundlage der von der Navigationseinrichtung zur Verfügung gestellten Information über die momentane Geschwindigkeit des Fahrzeugs.

2. Verfahren nach Anspruch 1, in welchem
die Festlegung der Abhängigkeit der zu regelnden Lautstärke des Audiosystems von der Geschwindigkeit des Fahrzeugs durch eine manuelle Einstellung durch einen Benutzer erfolgt.

3. Verfahren nach Anspruch 1, in welchem
die Festlegung der Abhängigkeit der zu regelnden Lautstärke des Audiosystems von der Geschwindigkeit des Fahrzeugs nach Maßgabe der Abhängigkeit des Geräuschpegels in dem Fahrzeug von der Geschwindigkeit des Fahrzeugs automatisch erfolgt.

4. Verfahren nach Anspruch 3, in welchem
die Abhängigkeit des Geräuschpegels in dem Fahrzeug von der Geschwindigkeit des Fahrzeugs mit Hilfe mindestens eines in dem Fahrgastraum installierten Mikrophons einmalig ermittelt und gespeichert wird.

5. Verfahren nach Anspruch 3, in welchem
die Abhängigkeit des Geräuschpegels in dem Fahrzeug von der Geschwindigkeit des Fahrzeugs mit Hilfe mindestens eines in dem Fahrgastraum installierten Mikrophons kontinuierlich während der Benutzung des Fahrzeugs ermittelt wird.

6. Verfahren nach einem der Ansprüche 3 - 5, in welchem zusätzlich
von dem Benutzer das gewünschte Verhältnis der zu regelnden Lautstärke zu dem ermittelten Geräuschpegel voreingestellt wird.

7. Verfahren nach einem der Ansprüche 3 - 6, in welchem zusätzlich
wahlweise die Abhängigkeit der zu regelnden Lautstärke des Audiosystems von der Geschwindigkeit des Fahrzeugs durch den Benutzer durch eine manuelle Einstellung geändert werden kann.

8. Verfahren nach einem der Ansprüche 2 - 7, in welchem zusätzlich
die Abhängigkeit der zu regelnden Lautstärke des Audiosystems von der Geschwindigkeit des Fahrzeugs von dem Benutzer individuell gespeichert werden kann.

9. Verfahren nach einem der vorangegangenen Ansprüche, in welchem
die geschwindigkeitsabhängige Lautstärkeregelung wahlweise ein- oder ausgeschaltet werden kann.

10. Verfahren nach einem der vorangegangenen Ansprüche, in welchem das Audiosystem umfasst
Lautsprecher und/oder ein Radio und/oder ein Kassetten-Wiedergabegerät und/oder einen CD-Spieler und/oder ein DVD-Wiedergabegerät und/oder eine Sprachausgabe der Navigationseinrichtung.

11. Navigationssystem für ein Fahrzeug, **dadurch gekennzeichnet, dass**
es einen Controller umfasst, der Signale zur Regelung der Lautstärke eines Audiosystems an dieses Audiosystem ausgibt, wobei diese Signale gemäß einem der Verfahren nach den obigen Ansprüchen codiert werden.
